Europäisches Patentamt

European Patent Office

Office européen des brevets

(19)

(11) Publication number: **0 110 555**
**A2**

## (12) EUROPEAN PATENT APPLICATION

(21) Application number: **83306519.6**

(22) Date of filing: **26.10.83**

(51) Int. Cl.³: **H 03 H 11/12**

(30) Priority: **26.10.82 GB 8230548**

(43) Date of publication of application: **13.06.84**
**Bulletin 84/24**

(84) Designated Contracting States: **AT BE CH DE FR GB IT LI LU NL SE**

(71) Applicant: **Voice Microsystems Limited, Abercynon, Mountain Ash Mid Glamorgan Wales CF45 4SF (GB)**

(72) Inventor: **Thomas, Louis David, Haulwen Villa Joiners Road Three Crosses, Gower West Glamorgan Wales (GB)**
Inventor: **Riggs, William, 18, Station Road Church Village, Mid Glamorgan Wales (GB)**

(74) Representative: **Robinson, John Stuart et al, Marks & Clerk 57/60 Lincoln's Inn Fields, London WC2A 3LS (GB)**

(54) Improvements in or relating to state variable filters.

(57) A programmable state variable filter includes a pair of integrators 3, 6. An electronically programmable attenuator 2, 4 in the form of a multiplying digital-to-analog converter is connected in series with the input of each integrator. The digital inputs of the converters are connected together and permit programming of the resonant or turnover frequency of the filter. There is also provided a tone detecting apparatus and a tone generating apparatus incorporating the filter.

EP 0 110 555 A2

## IMPROVEMENTS IN OR RELATING TO STATE

## VARIABLE FILTERS

The present invention relates to state variable filters having programmable resonant or turnover frequencies. Such filters may be used in the generation or detection of tones, for instance in telecommunications applications. Examples of such applications are in telephone exchanges and in telephone handsets.

According to a first aspect of the invention, there is provided a programmable state variable filter having two integrators and an electronically programmable attenuator connected in series with the input of one of the integrators for programming the resonant or turnover frequency of the filter characterized in that the attenuator comprises a multiplying digital to analog converter. Preferably, a further electronically programmable attenuator is provided, connected in series with the other of the integrators. More preferably the programming inputs of the attenuators are connected together.

Such a filter will generally operate in the bandpass mode, but could also be used in other modes, such as the lowpass mode.

According to a second aspect of the invention, there is provided an apparatus for detecting a tone, comprising a programmable filter according to the first aspect of of the invention for receiving an input signal, means for programming the resonant or turnover frequency of the filter, and means for comparing the level of the filter output signal with a reference level to produce an output signal indicative of the presence or absence of a tone.

According to a third aspect of the invention, there is provided an apparatus for generating a tone, comprising means for generating a waveform, a filter according to the first aspect of the invention for receiving the waveform, and means for programming the resonant or turnover frequency of the filter to the fundamental frequency of the waveform.

The invention will be further described, by way of example, with reference to the accompanying drawings, in which:

Figure 1 is a schematic circuit diagram of a first state variable filter constituting a preferred embodiment of the invention;

Figure 2 is a circuit diagram of a practical implementation of the filter of Figure 1;

Figure 3 is a schematic circuit diagram of a second state variable filter constituting a preferred embodiment of the invention;

Figure 4 is a circuit diagram of a practical implementation of the filter of Figure 3;

Figure 5 is a block diagram of a circuit for tone generation and detection constituting a preferred embodiment of the invention;

Figure 6 is a block diagram of a circuit for tone detection constituting a preferred embodiment of the invention; and

Figure 7 is a block diagram of a modification of the circuit of Figure 6.

Figure 8 is a block diagram of a circuit for tone generation constituting a preferred embodiment of the invention.

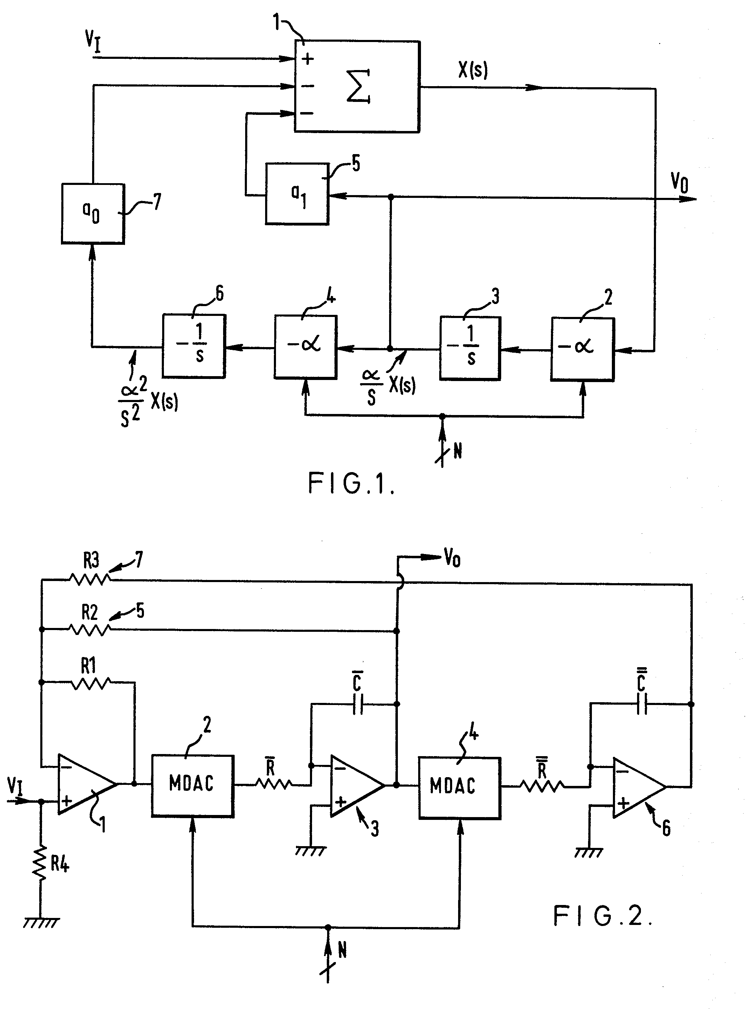

The state variable filter shown in Figure 1 of the drawings comprises a Summer 1 having a non-inverting input constituting the input of the filter for receiving an input signal $V_I$. The output of the summer is connected to the input of an electronically programmable attenuator 2 arranged to invert the signal and provide attenuation.

The output of the attenuator 2 is connected to the input of an inverting integrator 3, whose output is connected to a second electronically programmable attenuator 4, identical to the attenuator 2, and to the output of the filter for providing an output signal $V_O$. The attenuators 2 and 4 have control inputs connected together and constituting a programmable input of the filter.

The output of the integrator 3 is further connected via an amplifier 5 having a gain $a_1$ to a first inverting input of the summer 1. The output of the attenuator 4 is connected to the input of a further inverting integrator 6, whose output is connected via an amplifier 7 having a gain $a_0$ to a second inverting input of the summer 1.

With the exception of the programmable attenuators 2 and 4, the filter shown in Figure 1 is essentially a conventional state variable filter having a transfer function:

$$V_O(S) \, / \, V_I(S) = (s) \, / \, (s^2 + sa_1 + a_0).$$

The inclusion of the two programmable attenuators 2 and 4 results in the transfer function of the band-pass filter shown in Figure 1 as follows :

$$V_O(S) \, / \, V_I(S) = (s \, \alpha) \, / \, (s^2 + s \, a_1 \, \alpha + a_0 \, \alpha^2)$$

The resonant frequency of this filter is given by the expression :

$$\omega_o = \alpha \sqrt{a_0},$$

and the Q - factor is :

$$Q = \sqrt{a_0} \, / \, a_1.$$

The gain at resonance is :

$$G_o = 1/a_1.$$

Thus, the resonant frequency of the filter is proportional to the programmable gain or attenuation of the programmable attenuators 2 and 4, whereas the gain at resonance and the Q-factor are independent of this attenuation and of the frequency.

The control inputs of the attenuators 2 and 4 are shown in Figure 1 as comprising N-line busses connected in parallel and to a frequency control input of the filter. In a particularly preferred embodiment, the attenuators 2 and 4 comprise multiplying digital -to-analog converters (MDAC's) arranged to multiply the signal at their analog input by the number represented digitally on their digital inputs. Thus, the resonant frequency of the filter may be controlled by applying a number, proportional to the desired resonant frequency, on the bus, for instance from a microprocessor.

Figure 2 shows a practical implementation of the programmable state variable filter of Figure 1 with like parts being referred to by the same reference numerals. In particular, the summer comprises an operational amplifier having differential inputs with a feedback resistor R1 , a non-inverting input shunt resistor R4, and inverting input resistors R2 and R3. The resistors R2 and R3 together with the operational amplifier and resistor R1 constitute the amplifiers 5 and 7 of Figure 1. The integrator 3 comprises a further operational amplifier having a feedback c capacitor $\overline{C}$ and an input resistor $\overline{R}$, whereas the integrator 6 comprises another operational amplifier having a feedback capacitor $\overline{\overline{C}}$ and an input resistor $\overline{\overline{R}}$. The time constant of the integrator 3 is given by $T_1 = \overline{R}\,\overline{C}$, and the time constant of the integrator 6 is given by $T2 = \overline{\overline{R}}\,\overline{\overline{C}}$. Thus, the resonant frequency of the filter is given by $\omega_0 = \propto \sqrt{1/T1.\,T2}$. In general, $T1 = T2 = T$, so that the resonant frequency is given by :

$$\omega_0 = \propto / T.$$

The Q-factor is given by :

$$Q = 2.\ R2/R1,$$

and the gain at resonance is given by :

$$G_0 = 2\,(1 + R1/R2).$$

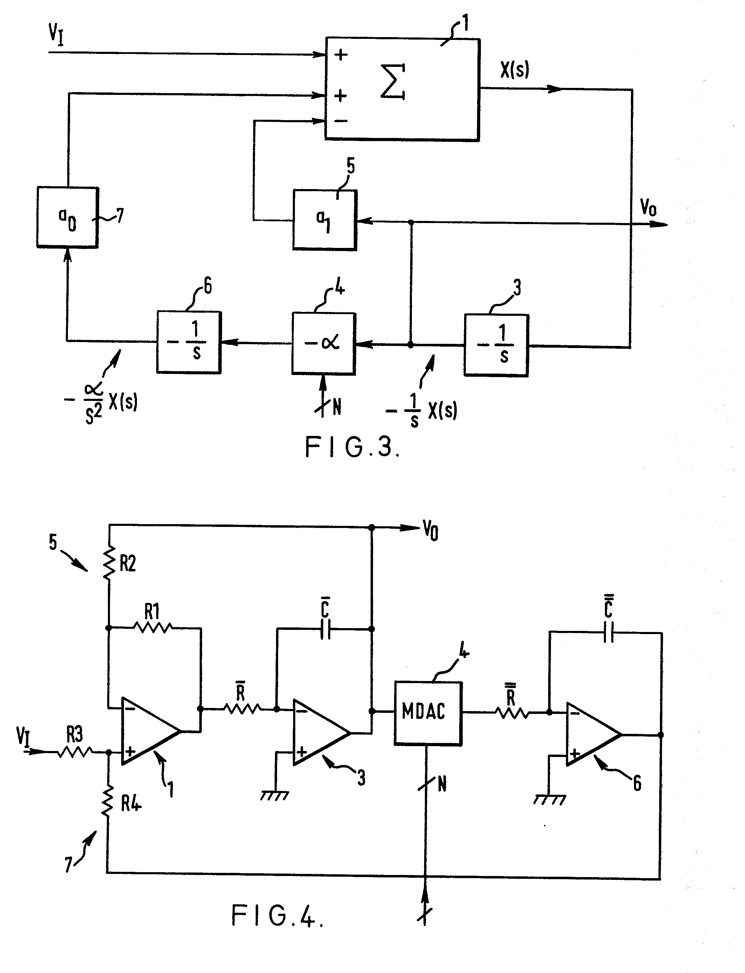

Figure 3 shows another programmable state variable filter similar to that shown in Figure 1 and in which like parts are referred to by the same reference numerals. The only difference between the filters of Figure 1 and Figure 3 is that the electronically programmable attenuator 2 is omitted in the filter of Figure 3. The transfer function of the filter of Figure 3 is given by :

$$V_0\,(S)\,/\,V_I\,(S) = (-s)\,/\,s^2 + sa_1 + a_0 \propto ).$$

The resonant frequency is given by :

$$\omega_0 = \sqrt{a_0\,\propto},$$

The Q-factor is given by :

$$Q = 2\sqrt{a_0}\,\alpha/\,a_1,$$

and the gain at resonance is given by :

$$G_o = -\,1/a_1.$$

The filter of Figure 3 thus has the advantage that it is more economical in components, but has the disadvantages that the resonant frequency is not a linear function of $\alpha$ and that the Q-factor is not constant, but varies with $\alpha$.

Figure 4 shows a practical implementation of the filter of Figure 3 with like parts being referred to by the same reference numerals. Using the same notation as that used with respect to the filter shown in Figure 2, the resonant frequency of the filter of Figure 4 is given by :

$$\omega_o = \sqrt(\alpha.C/T1.T2,$$

the Q-factor is given by:

$$Q = (2/B)\sqrt{\alpha}.C,$$

and the gain at resonance is given by :

$$G_o = -\,A/B,$$

where:

A = (R4/(R3 + R4)) (1 + R1/R2):

B = R1/R2; and

C = (R3/(R3 + R4)) (1 + R1/R2).

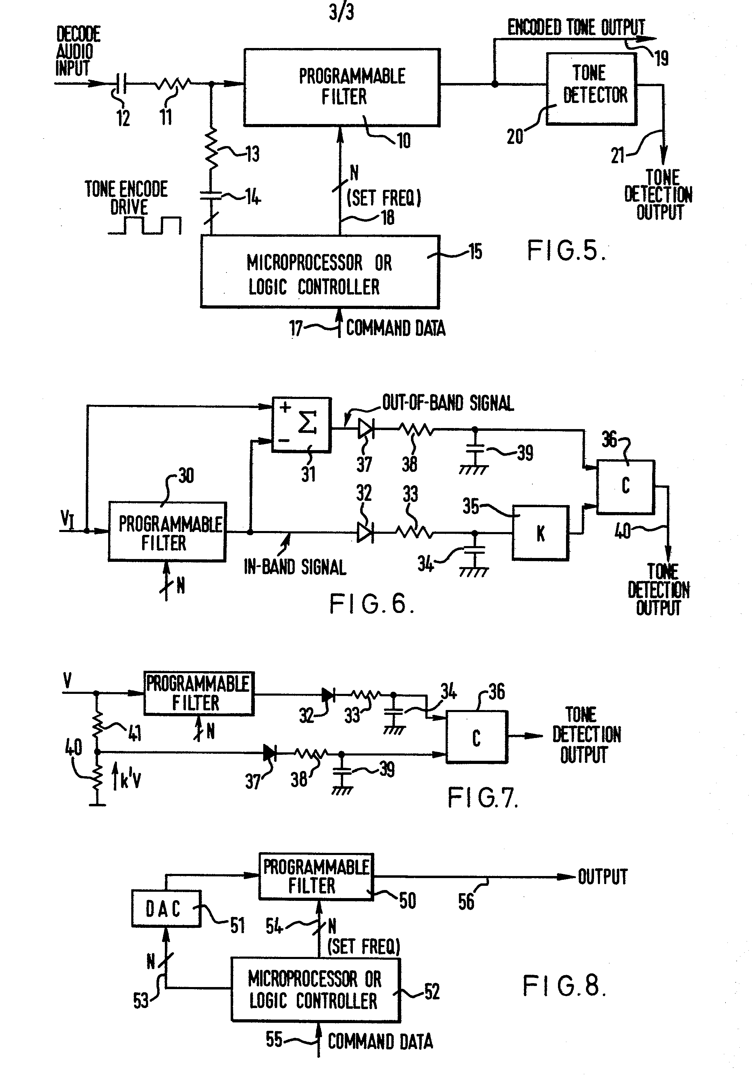

Figure 5 shows a circuit for tone detection and generation using a programmable state variable filter

0110555

10 of the type shown in any of the previous figures. The input of the programmable filter 10 is connected via a resistor 11 and capacitor 12 to an input for receiving a decoded audio signal including tones whose frequencies are to be detected. The input of the filter 10 is also connected via a resistor 13 and a capacitor 14 to an output of a microprocessor or logic controller 15. The microprocessor or logic controller 15 has a command data input 17 and an N-line bus. output 18 connected to the programming inputs of the filter 10. The output of the filter 10 is connected to an output 19 of the circuit for supplying an encoded tone output and to the input of a tone detector 20 whose output provides a tone detection output at 21.

When the circuit shown in Figure 5 is in the decode mode, the microprocessor or logic controller 15 sets the resonant frequency of the programmable filter 10, via the bus 18, to the required frequency. The tone detector 20 compares the level of the output signal from the filter 10 with a predetermined value so that, when a tone at the resonant frequency of the filter 10 is supplied to the input thereof, the tone detector 20 provides a signal as the output 21 indicating detection of the tone. However, if a tone having a frequency different from the resonant frequency of the filter is received, then the output

0110555

signal of the tone detector 20 is such as to indicate that a tone having the same frequency as the resonant frequency of the filter 10 is not being received.

In the encode mode, the microprocessor or logic controller 15 supplies a square wave of desired frequency _via_ the capacitor 14 and the resistor 13 to the input of the programmable filter 10. The microprocessor or logic controller set the resonent frequency of the filter to the fundamental frequency of the square wave, so that the filter 10 substantially removes the harmonics from the square wave to provide a sine wave output at the output 19 of accurate frequency and of good purity. The purity of the sine wave depends upon the Q-factor of the filter. Thus, when the filter has a Q of 20, the tone thus produced will have a total harmonic distortion of approximately 1.5 percent (a measured value).

Figure 6 shows another circuit for the detection of tones including a programmable filter 30 of the type shown in any one of Figures 1 to 4. The programming input of the filter 30 may be connected to a microprocessor or logic controller, as in the case of the circuit of Figure 5.

The input of the circuit is connected to the input of the filter 30 and also to a non-inverting input of a summer 31. The output of the filter 30 is connected to an inverting input of the summer 31 and also $\underline{via}$ an envelope detector comprising a diode 32, a resistor 33, and a capacitor 34 to the input of a weighting circuit 35. The weighting circuit 35 applies an attenuation or gain to the envelope signal by effectively multiplying the signal by a factor K, which may be larger or smaller than unity.

The outputof the weighting circuit 35 is connected to one input of a comparator 36 whose other input is connected $\underline{via}$ a further envelope detecting circuit comprising a diode 37, a resistor 38, and a capacitor 39 to the output of the summer 31.

The circuit of Figure 6 operates as follows. The resonant frequency of the programmable filter 30 is set to the value of a tone to be detected. Thus, when the input signal $V_I$ is a tone of this frequency, this signal is passed by the filter 30 to the summer 31, which also receives the signal direct from the input of the circuit. Thus, the out-of-band signal at the output of the summer 31 has a zero or relatively low value, whereas the in-band signal at the output of the filter has a relatively large value. The comparator 36 thus compares the out-of-band signal with the in-band signal, after weighting by the circuit 35, and provides an output signal at the output 40 indicating that a tone of the correct frequency has been received.

When a tone of a different frequency is received the in-band signal at the output of the filter 30 is of relatively low level whereas the out-of-band signal at the output of the summer 31 is of relatively high value. The comparator 36 compares the level of the two signals and provides a signal at the output 40 indicating that the desired tone has not been received.

The circuits of Figures 5 and 6 may be used for the generation and/or detection of audio tones for tone signaling in communication systems. These circuits provide reliable detection of tones of various frequencies and are capable of interfacing simply with microprocessor controllers and the like. Similarly, tones of accurately determined frequency can be generated for signaling purposes with the frequency of the tone being under microprocessor control.

Figure 7 shows a modification of the tone detecting circuit of Figure 6, in which the differencing circuit is removed and a weighting circuit is provided on the out-of-band signal path. As the description of the embodiment of Figure 6 indicates, attenuation or gain may be applied in the in-band path, however, in practice only gain is required. The same effect is more readily obtained by introducing attenuation, e.g. by means of resistors 40, 41 in the out-of-band path. In the following explanation, factor k is the attenuation in the out-of-band path.

Tone Detection Output, T, may be represented by

$$T = \text{sgn} \, (v_i - kv_0)$$

where sgn (signum) represents the operation of the comparator and $v_i$ and $v_0$ are signals proportional to the in-band and out-of-band voltages respectively. Factor k is an attenuation in the out-of-band signal path.

Now, $V_0 = V - v_i$

where V is the input to the tone detector

$$\therefore \quad T = \text{sgn} \, (v_i \, (1 + k) - kV)$$
$$= \text{sgn} \, (v_i - \frac{k}{1+k} \, V)$$

Hence the out-of-band signal $V_0$ need not be explicitly generated and the differencing stage 31 can be removed from the circuit of Figure 6, giving the circuit of Figure 7.

For the required attenuation factor k, a new attenuation factor $k^1$, given by

$$k^1 = \frac{k}{1 + k}$$

is established with two resistors and the comparator simply compares the in-band signal with another signal that is $k^1$ times the input signal.

Figure 8 shows a circuit for tone generation using a programmable state variable filter 50 of the type shown in any of Figures 1 to 4. The input of the programmable filter 50 is connected to the output of a digital-to-analog converter 51 whose digital inputs are connected to an output port of a microprocessor 52 via an N-line bus 53. The microprocessor 52 has another output port, connected via an N-line bus 54 to the programming inputs of the filter 50, and a command data input 55. The output 56 of the filter 50 forms the output of the tone generation circuit.

The microprocessor or logic controller 52 supplies a sequence of binary numbers to the converter 51 giving a best approximation of the required sinewave. The output of the converter 51 thus comprises a staircase waveform constituting a close approximation to the required sinewave. The resonant frequency of the programmable filter 50 is set by the microprocessor or logic controller 52 to the fundamental frequency of the required sinewave so as to filter out the higher harmonics of the staircase waveform. It is thus possible to provide sinewaves having exceedingly low distortion, total harmonic distortion figures of 0.00025 % being achievable.

CLAIMS

1. A programmable state variable filter having two integrators 3, 6 and an electronically programmable attenuator 2, 4 connected in series with the input of one of the integrators 3, 6 for programming the resonant or turnover frequency of the filter, characterised in that the attenuator 3, 4 comprises a multiplying digital-to-analog converter.

2. A filter as claimed in claim 1, arranged as a band-pass filter.

3. An apparatus for detecting a tone, characterised in that it comprises a programmable filter as claimed in claim 1 or 2, for receiving an input signal, means 15 for programming the resonant or turnover frequency of the filter, and means 20, 36 for comparing the level of the filter output signal with a reference level to produce an output signal 21, 40 indicative of the presence or absence of a tone.

4. An apparatus as claimed in claim 3, characterised in that the programming means comprises a microprocessor or logic controller 15 for programming the resonant frequency of the filter to the frequency of a tone to be detected.

5. An apparatus as claimed in claim 3 characterised in that the programming means comprises a microprocessor or logic controller 15 arranged to programme the resonant frequency of the filter to a plurality of values in turn so as to determine the frequency of a received tone.

6. An apparatus as claimed in claim 3, 4 or 5, characterised in that the comparing means comprises a comparator 36 having a first input connected via a first envelope detector 32, 33, 34 to the output of the filter and a second input connected via a second envelope detector 37, 38, 39 to the output of means 31 for subtracting the output signal of the filter 30 from the input signal thereto or to the input signal to the filter.

7. An apparatus as claimed in claim 6, characterised in that an input of the comparator 36 is connected to its respective input signal via a weighting circuit 35, 40, 41.

8. An apparatus for generating a tone, characterised in that it comprises means for generating a waveform 51, 52, a filter 50 as claimed in claim 1 or 2 for receiving the waveform, and means 52, 55 for programming the resonant or turnover frequency of the filter to the fundamental frequency of the waveform.

9.  An apparatus as claimed in claim 8, characterised in that the waveform generating means 51, 52 is arranged to generate a square or rectangular waveform.

10. An apparatus as claimed in claim 8, characterised in that the waveform generating means 51, 52 is arranged to generate a staircase waveform approximating a sinewave.

FIG.1.

FIG.2.

0110555

FIG.3.

FIG.4.

0110555

3/3

**FIG.5.**

DECODE AUDIO INPUT → 12 — 11 — 13 — 14 (TONE ENCODE DRIVE) — PROGRAMMABLE FILTER (10) — ENCODED TONE OUTPUT (19) — TONE DETECTOR (20) — (21) TONE DETECTION OUTPUT

N (SET FREQ) (18) — MICROPROCESSOR OR LOGIC CONTROLLER (15) — (17) COMMAND DATA

**FIG.6.**

$V_I$ → PROGRAMMABLE FILTER (30) — N — IN-BAND SIGNAL — OUT-OF-BAND SIGNAL — $+$ $-$ $\Sigma$ (31) — (37) (38) (39) — (32) (33) (34) — K (35) — C (36) (40) — TONE DETECTION OUTPUT

**FIG.7.**

V → PROGRAMMABLE FILTER — N — (32) (33) (34) — (36) C — TONE DETECTION OUTPUT

(40) (41) $\uparrow k'v$ — (37) (38) (39)

**FIG.8.**

PROGRAMMABLE FILTER (50) — (56) OUTPUT

DAC (51) — N (54) (SET FREQ) — N (53) — MICROPROCESSOR OR LOGIC CONTROLLER (52) — (55) COMMAND DATA